# EUROPEAN PATENT APPLICATION

(11) **EP 4 583 010 A1**
(43) Date of publication of application: **09.07.2025**
(21) Application number: 24222650.4
(22) Date of filing: 20.12.2024
(51) Int. Cl.: G06N 10/40, H10N 69/00

(54) **QUANTUM PROCESSING CIRCUIT, QUANTUM COMPUTING SYSTEM AND QUANTUM COMPUTING ARRANGEMENT**

(30) Priority: 02.01.2024 FI 20245003
(71) Applicant: IQM Finland Oy, 02150 Espoo (FI)
(72) Inventor: TAKALA, Eelis, 02150 Espoo (FI)
(74) Representative: Berggren Oy

(57) **Abstract**

A quantum processing circuit comprising a substrate and a resonator arranged in the substrate body. The resonator is arranged at a distance, in the z-direction, from circuit elements on the first surface of the substrate. The resonator extends in the z-direction from a surface of the substrate into the substrate body and toward the circuit elements.

## Description

### FIELD OF THE DISCLOSURE

The present disclosure relates to quantum computing, and particularly to resonators in quantum processing circuits.

### BACKGROUND OF THE DISCLOSURE

Quantum computers often contain a quantum processor circuit where circuit elements lie on a substrate. These circuit elements typically include qubits and signal transmission lines coupled to qubits. Qubit control and readout can be performed with electrical signals which exhibit electrical resonance in some transmission lines. These transmission lines may be called resonators.

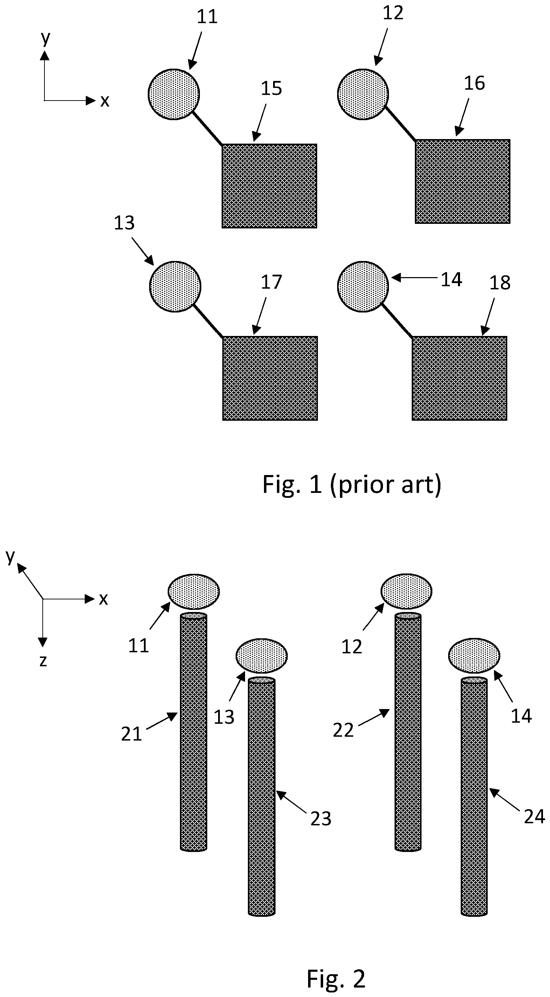

Figure 1 illustrates schematically qubits 11 - 14 arranged in a lattice geometry on the surface of the substrate (illustrated as the xy-plane). Transmission lines 15 - 18 may also be arranged on the surface of the substrate.

If the qubits 11 - 14 are packed very close to each other on the surface of the substrate, the transmission lines 15 - 18 must be brought close to each other in many regions on the surface of the substrate. The transmission lines connected to one qubit may even have to transmission lines connected to other qubits. Close packing of transmission lines can lead to crosstalk between adjacent transmission lines, which disturbs the operation of the quantum computer.

The transmission line arrangement needed for addressing the qubits 11 - 14 may therefore restrict the maximal qubit packing density (number of qubits per surface unit). It would be desirable to develop transmission line arrangements where such restrictions are relaxed, so that qubits can be placed closer to each other on the surface of the substrate.

### BRIEF DESCRIPTION OF THE DISCLOSURE

An object of the present disclosure is to provide a transmission line arrangement which alleviates the above problem.

The object of the disclosure is achieved by devices which are characterized by what is stated in the independent claims. Some embodiments of the disclosure are disclosed in the dependent claims.

The disclosure is based on the idea of arranging a transmission line inside the substrate, substantially perpendicular to the substrate surface. An advantage of this arrangement is that the number of surface transmission lines can be reduced.

### BRIEF DESCRIPTION OF THE DRAWINGS

The following disclosure refers to accompanying drawings, in which:
Figure 1 illustrates qubits and resonators in an xy-plane.
Figure 2 illustrates qubits in the xy-plane and resonators which do not lie in the xy-plane.
Figures 3a - 3d illustrate cavities in a substrate.
Figures 4a - 4b illustrate a first embodiment.
Figures 5a - 5b illustrate a first alternative in a second embodiment.
Figures 6a - 6b illustrate a second alternative in the second embodiment.
Figures 7a - 7b illustrate geometric options related to the second embodiment.
Figure 8 illustrates a third embodiment.
Figures 9a - 9d illustrate a fourth embodiment, which may be implemented together with either the second or the third embodiment.

### DETAILED DESCRIPTION OF THE DISCLOSURE

Figure 2 illustrates schematically the general idea of this disclosure. The surface of a substrate is illustrated as the xy-plane, and the z-direction is a direction which is perpendicular to the xy-plane. Qubits 11 - 14 are arranged in the xy-plane, but resonators 21- 24 do not lie in the xy-plane. Instead, they are located in the substrate, beneath the qubits, where they extend in the z-direction.

More specifically, this disclosure describes a quantum processing circuit which comprises a substrate. The substrate defines an xy-plane and a z-direction which is perpendicular to the xy-plane. The substrate comprises a first surface and a second surface. The substrate comprises a substrate body which extends from the first surface to the second surface.

The quantum processing circuit comprises one or more circuit elements on the first surface of the substrate. The quantum processing circuit also comprises a resonator arranged in the substrate body.

The resonator is arranged at a distance, in the z-direction, from the one or more circuit elements on the first surface of the substrate. The resonator extends in the z-direction from the second surface of the substrate into the substrate body and toward the one or more circuit elements.

The one or more circuit elements may comprise a qubit. The qubit may define a qubit region on the first surface of the substrate. The resonator may be aligned with the qubit region in the z-direction, so that the resonator is arranged at a distance from the qubit region, and it extends toward the qubit. The qubit may comprise a qubit charge island. The resonator may be arranged beneath this qubit charge island. The resonator may thereby be coupled to the qubit, as described in more detail below.

However, the resonator does not have to be arranged directly below the charge island of a qubit, or even directly below a qubit. The one or more circuit elements on the first surface of the substrate may for example comprise a coupling charge island. The coupling charge island may be coupled to a qubit charge island without being a part of the qubit itself. The resonator may be arranged beneath this coupling charge island. The resonator may thereby be coupled to the qubit via the coupling charge island.

The resonator may alternatively be arranged beneath other circuit elements on the first surface of the substrate, which are not qubit charge islands or coupling charge islands. The optimal location and geometry the resonator, and its arrangement in relation to the circuit elements on the first surface of the substrate, will depend on the technical function which the resonator is intended to perform.

The resonator may form a part of a transmission line, and/or it may be connected to other circuit elements which form a transmission line. The resonator may be configured to transfer input signals from other circuit elements to the qubit, or to transfer output signals from the qubit to other circuit elements.

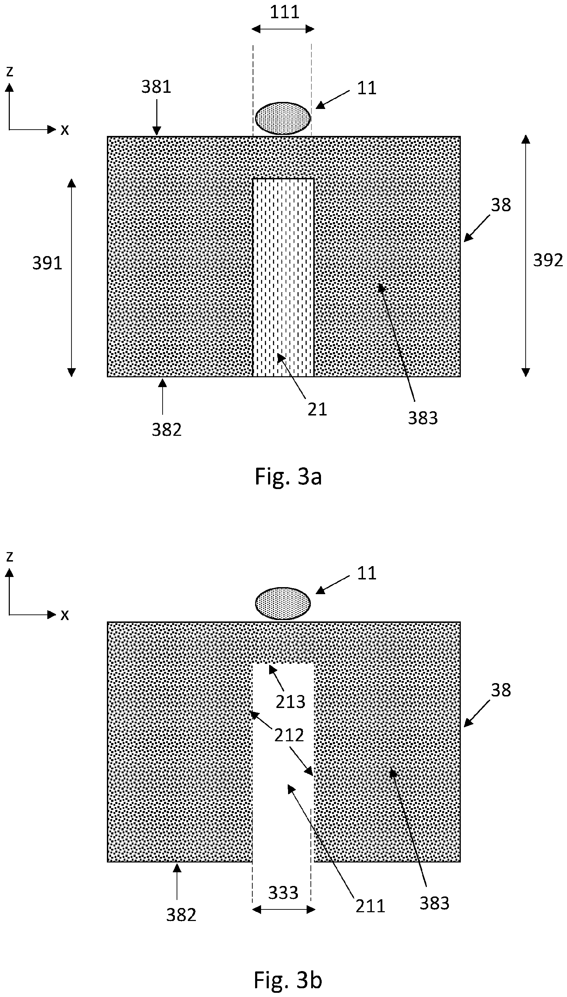

Figure 3a illustrates the substrate 38. The substrate can for example be made of silicon, sapphire or a ceramic material. Other substrates may also be used. The thickness 392 of the substrate in the z-direction may be much greater than its length in the x-direction and its width in the y-direction. The substrate 38 thereby defines an xy-plane. This xy-plane may for example be defined by the first surface 381 of the substrate or by the second surface 382 of the substrate. The substrate 38 also comprises a substrate body 383 between the first (381) and second (382) surfaces.

The quantum processing circuit may comprise many different circuit elements 11 on the first surface 381. They may include a qubit which defines a qubit region 111 on the first surface 381 of the substrate 38. The circuit element 11 may for example be a qubit charge island. Alternatively, it may be a coupling charge island, as described above.

In this disclosure, the term "charge island" refers to an electrically conductive object which has a floating electric potential. In other words, it is not set to any specific electric potential when the quantum processing circuit is used. Instead, its electric potential is continuously influenced by the other circuit elements which are adjacent to the charge island.

The qubit may for example be a transmon or unimon qubit. The qubit may comprise a Josephson junction. The one or more circuit elements in the quantum processing circuit may also comprise one or more transmission lines (not illustrated) on the first surface 381 of the substrate 38. These transmission lines may be coupled to the qubit. These transmission lines may for example be a signal input line, a flux input line or a signal readout line. These transmission lines may be microwave resonators.

The quantum processing circuit may also comprise additional circuit elements (not illustrated) on the second surface 382 of the substrate. These additional circuit elements may be electrically connected or coupled to the resonator 21 on the second surface 382 of the substrate 38.

A resonator 21 has been formed in the substrate body 383. This resonator 21 may be located below the circuit element 11 on the first surface 381 of the substrate 38. The resonator 21 is illustrated precisely below the qubit region 111 in figure 3a, but it may alternatively be located adjacent to the qubit region, at xy-coordinates which differ from the xy-coordinates of the qubit region 111.

The height (or thickness) 391 of the resonator 21 in the z-direction may be less than the thickness 392 of the substrate 38. Consequently, the resonator 21 may not extend all the way to the circuit element 11 on the first surface 381. The resonator 21 may nevertheless be electromagnetically coupled to the circuit element 11, so that a signal can be transferred between the circuit element 11 and the resonator 21.

In any embodiment presented in this disclosure, the diameter 3b of the first cavity 211 may be in the range 1 - 10 µm, or in the range 1 - 50 µm, or in the range 1 - 100 µm.

The resonator may be a microwave resonator or a waveguide. The resonator line may for example be a signal input resonator or a signal readout resonator. In the signal input case, a signal coming from a transmission line may exhibit electrical resonance in the resonator. In the signal readout case, the properties of an electromagnetic wave in the resonator may be sensitive to the state of the qubit.

The term "resonator" refers in this disclosure to a conductive element with a finite height 391. The conductive element has a first end and a second end. The length 391 is measured (in the illustrated z-direction) from the first end to the second end along the element. The first end may be inside the substrate body, and the second end may be adjacent to the second surface of the substrate.

The conductive element may terminate inside the substrate body at its first end, beneath the first surface of the substrate. The first end may be connected to the one or more circuit elements on the first surface of the substrate via capacitive contact. The circuit element which the resonator is coupled to may be a charge island, as mentioned above.

An electromagnetic signal may resonate as a standing wave in the resonator. The signal wavelength may be in the millimeter - centimeter range. Consequently, the length 391 of any resonator described in this disclosure may for example be in the range 50 - 500 µm. However, other lengths are also possible. The required length depends on the materials of the resonator.

Figure 3b illustrates a substrate body 38 which comprises a first cavity 211. The first cavity 211 is delimited in the xy-plane at least by a first central wall 212. The first cavity 211 may extend in the z-direction from the second surface 382 of the substrate 38 into the substrate body 383 and toward the circuit element 11 on the first surface of the substrate. The resonator 21 may comprise a central conductor formed by a first layer (not illustrated in figure 3b) of conductive material on the first central wall 212 of the first cavity 211.

The term "cavity" refers in this disclosure to a region of the substrate body where the substrate material has been removed, for example by etching. Other materials may be deposited into the cavity, and they may fill the cavity. In other words, the cavity is not necessarily an open space filled with gas or vacuum. It may be at least partly filled with gas or vacuum, but it may alternatively be filled with other materials, as described below, so that no free space remains. If the substrate 38 is made of silicon, any cavity described in this disclosure may be prepared with etching processes which are used to create through-silicon-vias (TSV).

The expression "a cavity is delimited in the xy-plane" means, using the first cavity 211 as an example, that a line parallel to the xy-plane can be drawn from any point inside the first cavity 211 to the first central wall 212. However, in the z-direction the first cavity 211 may be delimited by a top wall 213, not by the first central wall 212.

The resonator 21 may be formed by coating the first central wall 212 in the first cavity 211 with the first layer of conductive material. The first cavity 211 may be filled with a filler material after the first central wall 212 has been coated. This option will be discussed in more detail below. The resonator 21 may comprise the filler material.

In any embodiment presented in this disclosure, the first central wall 212 may be parallel to the z-axis. The first cavity 211 and the resonator 21 may extend linearly in the z-direction. However, the first cavity 211 and the resonator 21 may alternatively be slightly tilted in relation to the z-axis. The first central wall 212 may in this case for example be tilted by less than 15 degrees or less than 30 degrees in relation to the z-axis.

In any embodiment presented in this disclosure, the first cavity 211 and the resonator 21 may have the shape of an elongated cylinder, cuboid, prism, pyramid, trapezoid, cone or truncated cone. In all of these cases, the first cavity 211 may comprise only a single, continuous sidewall which forms the first central wall 212, as figure 3b illustrates. The shape options listed above apply also to the second and third cavities, which are presented in the embodiments below.

In any embodiment presented in this disclosure, the first central wall 212 may be circular in the xy-plane. Other shapes are also possible, as the previous paragraph indicates.

In any embodiment presented in this disclosure, the first cavity may be delimited in the xy-plane by the first central wall and a second central wall, so that the first cavity extends from the first central wall to the second central wall.

In this case the term "delimited in the xy-plane" means that a line parallel to the xy-plane can be drawn from any point inside the first cavity 211 to both the first central wall and to the second central wall.

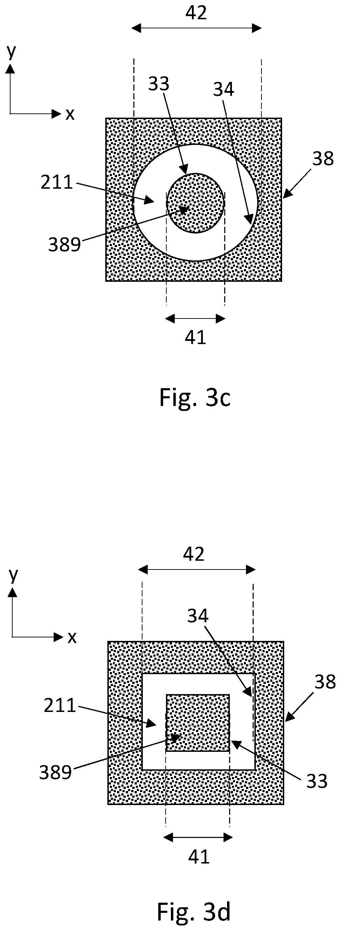

This is illustrated in figures 3c and 3d, where the substrate 38 surrounds the cavity 211 in the xy-plane, but the first cavity 211 also surrounds a central part 389 of the substrate 38 in the xy-plane. The central part 389 of the substrate 38 may be called the core of the first cavity 211.

In any embodiment presented in this disclosure, the diameter 41 of the central part 389 of the substrate 38 (which is also the inner diameter of the first cavity 211) may be in the range of 1 - 10 µm, or in the range 1 - 50 µm. The outer diameter 42 of the first cavity 211 may be only 1-5 µm wider than the inner diameter 41. Alternatively, the outer diameter 42 may be 5 - 50 µm wider than the inner diameter 41, or even 50 - 500 µm wider than the inner diameter 41. The optimal diameters depend on the material which fills the first cavity 211.

These diameter options apply also to the second and third cavities, which are presented in the embodiments below.

The first cavity 211 and the resonator may in figure 3c have the shape of an elongated toroid. The core 389 and the first cavity 211 may in this case both be circular in the xy-plane, as figure 3c illustrates. Figure 3d illustrates an alternative geometry where the core 389 and the first cavity 211 have a rectangular shape. In both figures 3c and 3d the first cavity 211 extends in the z-direction just as in figure 3b. The core 389 forms a central column in the first cavity 211.

It can be seen in figures 3c and 3d that the first cavity 211 here comprises two opposing sidewalls 33 and 34. The inner wall 33 is formed on the core 389 of the first cavity 211 and the outer wall 34 is formed on the part of the substrate 38 which surrounds the first cavity 211. Either the inner wall 33 or the outer wall 34 may be utilized as the first central wall. The other wall then forms the second central wall mentioned above.

The outer sidewall 34 surrounds the inner sidewall 33. The inner and outer sidewalls may have the same shape in the xy-plane, as figures 3c and 3d illustrate. However, they may also have different shapes. The outer sidewall 34 may for example be rectangular and the inner sidewall 33 may be circular or elliptical, or vice versa. Any other shapes could also be used.

The inner and outer sidewalls 33 and 34 may be coaxial, as figures 3c and 3d illustrate. In other words, when viewed in the xy-plane, they may share the same central point inside the core 389. They may form concentric circles in the xy-plane. The first cavity 211 may then be called a coaxial cavity. However, the inner sidewall 33 and outer sidewall 34 do not necessarily have to be coaxial.

Regardless of whether or not the sidewalls 33 and 34 are coaxial, the core 389 may form a pillar which extends through the cavity in the z-direction. If the sidewalls 33 and 34 are coaxial, then the core 389 may be called a central pillar.

The first central wall may be circular in the xy-plane, and other walls described in this disclosure may form concentric circles with the first central wall in the xy-plane. Furthermore, the embodiments presented below will primarily illustrate cavities and resonators with circular walls in the xy-plane.

A circular coordinate system typically facilitates easier theoretical modelling of the resonator than other geometries do. However, walls and resonators with any other shape in the xy-plane (and any geometry in xyz-space) could alternatively be used, and their properties may be determined either experimentally or theoretically. The optimal layout and geometry of the resonator will depend at least on the desired resonance frequency and on the materials which are used to form conductors on cavity walls and to fill the cavity.

The central conductor formed by the first layer of conductive material on the first central wall 212 of the first cavity 211 may be called a columnar conductor. The columnar conductor may be coaxial with the cavity.

In any embodiment presented in this disclosure where a central conductor is used, the resonator may also comprise one or more peripheral conductors. The one or more peripheral conductors may be electrically separated from the central conductor. The one or more peripheral conductors may be placed around the central conductor in the xy-plane. The one or more peripheral conductors may, but don't necessarily have to, surround the central conductor in the xy-plane. The one or more peripheral conductors may be set to ground potential when the resonator is used.

In any embodiment presented in this disclosure, the resonator may also comprise a material 35 with high electric permittivity which fills the first cavity. The relative electrical permittivity of this material may for example be in the range 10 - 1000, or in the range 10 - 10 000. The material 35 may for example be silicon, or a material which has higher electric permittivity than silicon.

The first layer of conductive material, which forms the central conductor in the resonator, may, in any embodiment presented in this disclosure, be a superconducting material. The material may have a kinetic inductance in the range 50 - 500 pH / square, or in the range 100 - 300 pH / square. The material may for example be niobium nitride, or a material with higher kinetic inductance than niobium nitride.

A quantum computing system may comprise any quantum processing circuit described in this disclosure. A quantum computing arrangement may comprise any quantum processing circuit described in this disclosure.

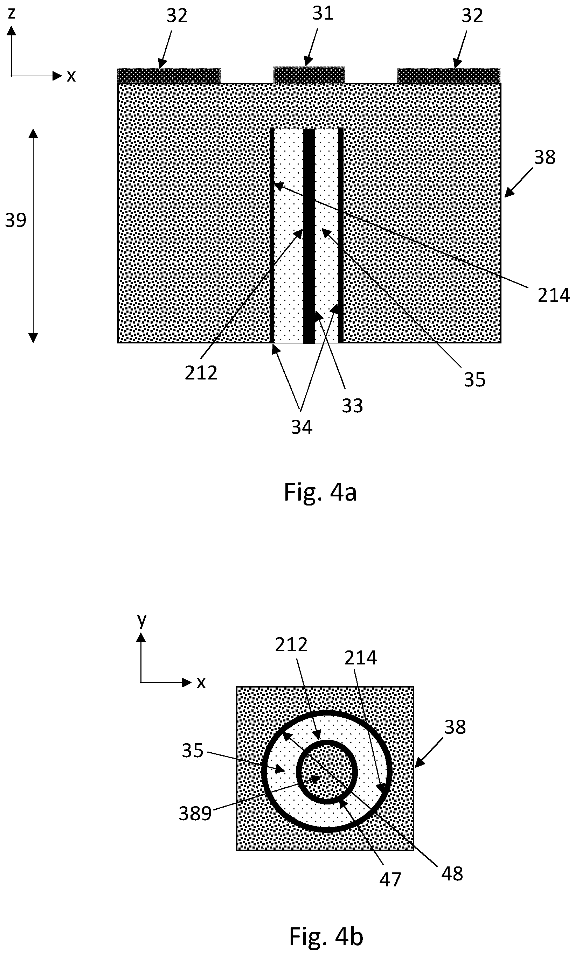

Figures 4a, 5a and 6a all illustrate circuit elements 31 and 32 on the first surface of the substrate. Reference number 31 corresponds to reference number 11 in figure 3a. Element 31 may for example be a qubit charge island or a coupling charge island, as described previously. Element 32 may be a conductor which is set to ground potential.

### First embodiment

Figures 4a - 4b illustrate a quantum processing circuit where a second central wall 214 surrounds the first central wall 212 in the xy-plane. In this circuit the resonator also comprises a peripheral conductor formed by a second layer of conductive material 48 on the second central wall 214 of the first cavity 211. The resonator comprises a central conductor formed by a first layer of conductive material 47 on the first central wall 212 of the first cavity 211.

In any embodiment presented in this disclosure, a layer of conductive material which lies on a central wall or a peripheral wall (such as layers 47 and 48 in figure 4b), and which reaches the top wall 213 (illustrated in figure 3b), may also at least partly cover the top wall 213.

### Second embodiment

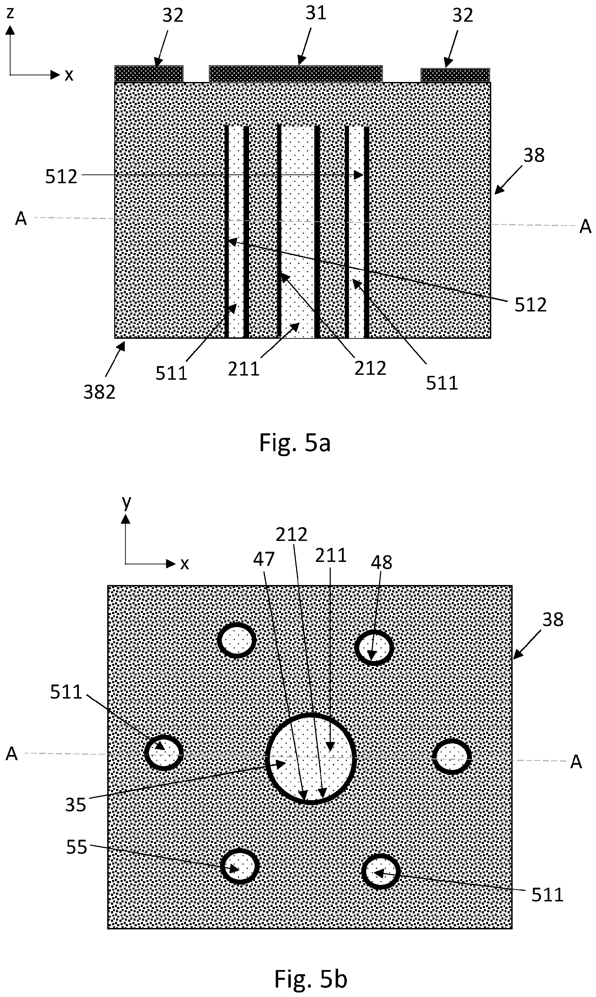

Figures 5a - 5b illustrate a quantum processing circuit where the substrate body 38 also comprises two or more second cavities 511 which extend in the z-direction from the bottom surface 382 of the substrate into the substrate body 38 and toward the one or more circuit elements on the first surface of the substrate. Each of the two or more second cavities 511 is delimited in the xy-plane at least by a first peripheral wall 512. The two or more second cavities 511 are located around the first cavity 211 in the xy-plane. The resonator also comprises a peripheral conductor in each second cavity 511. Said peripheral conductor is formed by a second layer of conductive material on the first peripheral wall 512 of said second cavity 511.

Figure 5b is an xy cross-section of figure 5a along the line A-A. The first cavity 211 may be delimited in the xy-plane only by the first central wall 212, as figures 5a - 5b illustrate.

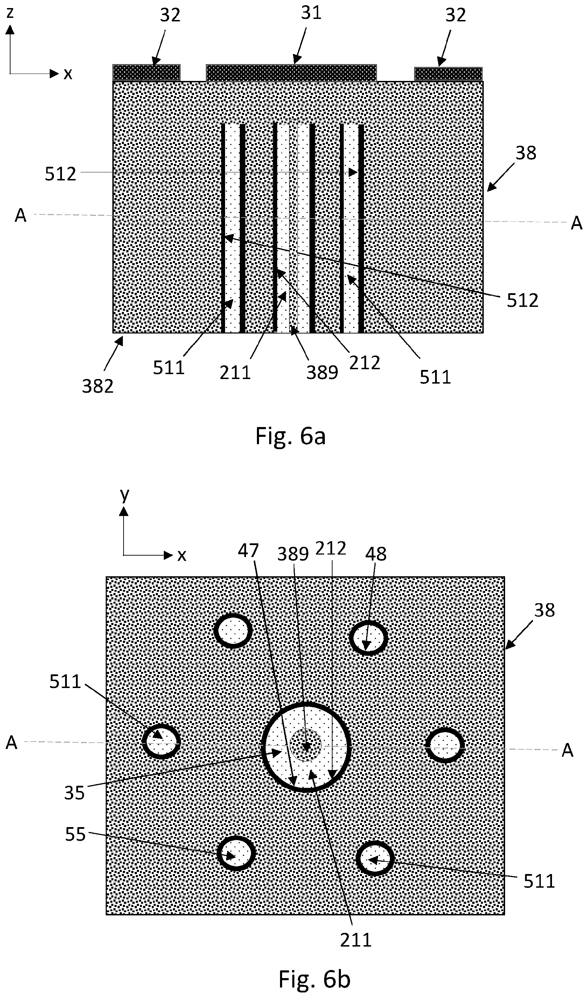

Another alternative, illustrated in figures 6a - 6b, is that the first cavity 211 may have the same shape in the xy-plane as in figures 4a and 4b. The substrate body then comprises a central part 389 which forms the core of the first cavity 211. The first cavity is then delimited by an inner wall and an outer wall. Either one of these walls could in that case be utilized as the first central wall. Figures 6a - 6b illustrate a device where the outer wall is the first central wall 212. The inner / outer wall which is not the first central wall 212 may be left uncoated. Other reference numbers in figures 6a - 6b correspond to those of figures 5a - 5b.

The options presented in the following paragraphs apply to both figures 5a -5b and to figures 6a - 6b. The peripheral conductors formed in the two or more second cavities 511 may be set to ground potential when the resonator is used.

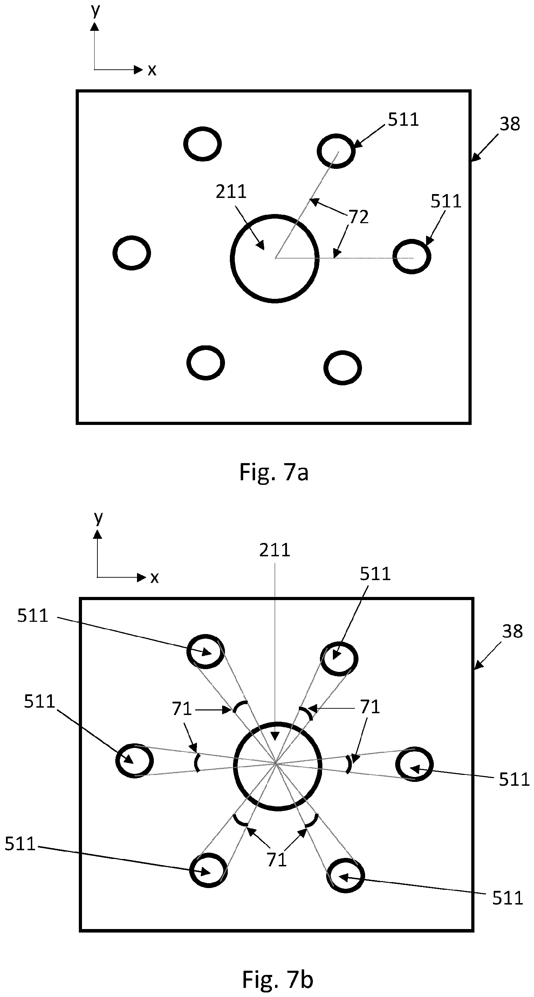

The two or more second cavities 511 may be placed substantially symmetrically around the first cavity 211 in the xy-plane. In figure 7a illustrates that the center of the first cavity 211 may be taken as a center point, and lines 72 may be drawn from the center of the first cavity 211 to the centres of each of the two or more second cavities 511 (only two lines 72 are illustrated). If the number of second cavities 511 is N, the angle between adjacent lines 72 may be substantially 360°/N. However, the two or more second cavities 511 may alternatively be placed around the first cavity in an asymmetric manner, so that the angle is different for at least some of these line pairs.

The diameters of the two or more second cavities 511 in the xy-plane may be freely chosen. Figure 7b illustrates the first cavity 211 and six surrounding second cavities 511. Each second cavity 511 covers an angle 71 of the field of view from the center of the first cavity 211. These angles do not necessarily have to be equal. The sum total of the angles 71 covered by the two or more second cavities 511, seen from the center of the first cavity 211, may for example be greater than 10 degrees, greater than 30 degrees, greater than 60 degrees, greater than 90 degrees, or greater than 180 degrees. In general, the optimal design of the two or more second cavities 511 may depend both on the desired resonator properties and on other circuit elements which lie close to the resonator that might disturb the operation of the resonator.

The height of the first cavity 211 in the z-direction may be substantially equal to the height of each of the two or more second cavities 511 in the z-direction. Alternatively, the height of the first cavity 211 may be greater than the height of the two or more second cavities, or the height of the two or more second cavities 511 may be greater than the height of the first cavity 211.

Each of the two or more second cavities 511 may for example be filled with a gas, vacuum, or an insulating material.

### Third embodiment

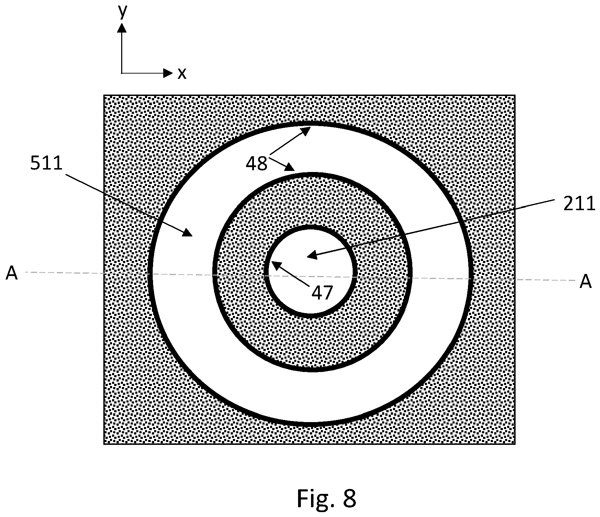

In an alternative embodiment, the substrate body may comprise a second cavity 511 which extends in the z-direction from the bottom surface of the substrate into the substrate body and toward the one or more circuit elements on the first surface of the substrate. The second cavity 511 may be delimited in the xy-plane at least by a first peripheral wall. The second cavity 511 may surround the first cavity 211 in the xy-plane. The resonator may comprise a peripheral conductor in the second cavity 511. Said peripheral conductor may be formed by a second layer of conductive material 48 on the first peripheral wall of the second cavity 511. Figure 8 illustrates this alternative in the xy-plane. The xz-cross-section along the line A-A may be the one shown in figure 5a above.

The second cavity 511 has the shape of an annulus in Figure 8, but any other shape could also be used. The second layer of conductive material 48 may be placed on the inner or the outer wall of the second cavity 511, as figure 8 illustrates. In other words, the first peripheral wall may in this case be either the inner or the outer wall of the second cavity 511. Alternatively, the second layer of conductive material 48 may be placed on both the inner and the outer wall. The peripheral conductor may be grounded when the device is in use. The options described above with reference to figures 6a and 6b, involving a central part 389 in the first cavity 211, could also be applied in figure 8.

The height of the first cavity 211 in the z-direction may be substantially equal to the height second cavity 511 in the z-direction. Alternatively, the height of the first cavity 211 may be greater than the height of the second cavity 511, or the height of the second cavity 511 may be greater than the height of the first cavity 211.

The second cavity 511 may for example be filled with a gas, vacuum, or an insulating material.

### Fourth embodiment

This fourth embodiment may be implemented with either the second embodiment or the third embodiment. All options described in the second and third embodiments above apply also to this fourth embodiment.

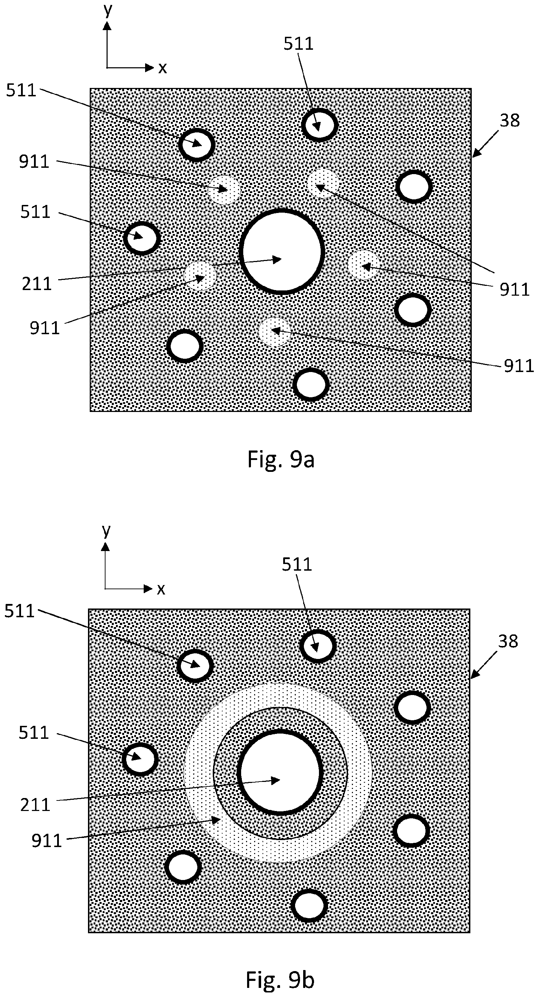

In this embodiment, illustrated in figures 9a and 9b, the substrate body 38 comprises one or more third cavities 911 which extend in the z-direction from the bottom surface of the substrate into the substrate body and toward the one or more circuit elements on the first surface of the substrate. The one or more third cavities 911 are located between the first cavity 211 and the one or more second cavities 511 in the xy-plane. The one or more third cavities 911 may be filled with a material which has higher electric permittivity than the substrate body 38.

In figures 9a and 9b, the first (211) and second (511) cavities have been implemented according to the second embodiment. In figure 9a, the one or more third cavities comprise five third cavities 911 placed around the first cavity 211 in the xy-plane. The number of third cavities 911 could alternatively be two or more in figure 9a. In figure 9b, the one or more third cavities comprise a single third cavity 911 which surrounds the first cavity 211 in the xy-plane.

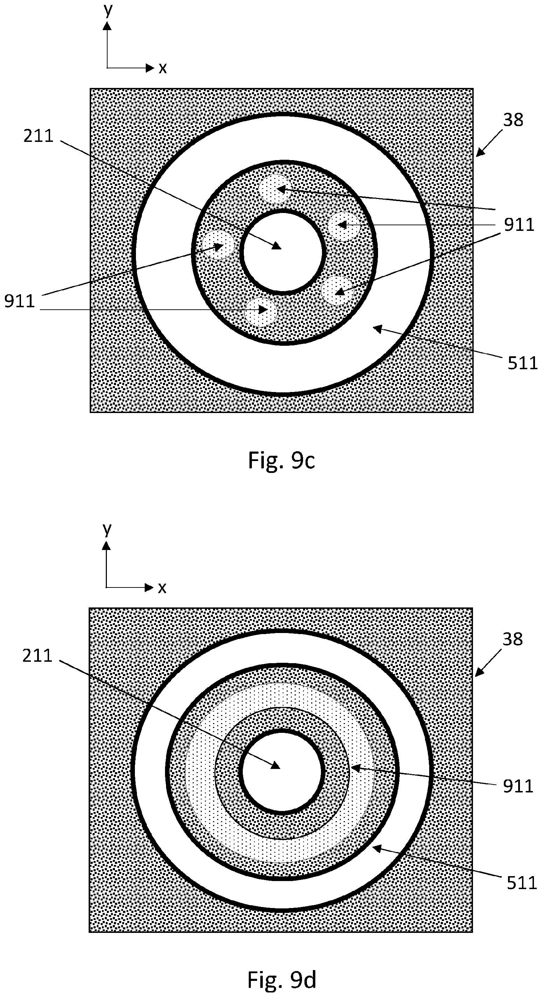

In figures 9c and 9d, the first (211) and second (511) cavities have been implemented according to the third embodiment. In figure 9c, the one or more third cavities comprise five third cavities 911 placed around the first cavity 211 in the xy-plane. The number of third cavities 911 could alternatively be two or more in figure 9c. In figure 9c, the one or more third cavities comprise a single third cavity 911 which surrounds the first cavity 211 in the xy-plane. The second cavity 511 surrounds the third cavity 911.

The third cavities 911 have circular shapes in figures 9a and 9c, and an annulus shape in figures 9c and 9d. Any other shape is also possible.

The dimensions of the one or more third cavities 911 in the xy-plane may be freely chosen. Similar to figure 7 above, the sum total of the angles covered by the two or more third cavities 911 in figures 9a and 9c, seen from the center of the first cavity 211, may for example be greater than 10 degrees, greater than 30 degrees, greater than 60 degrees, greater than 90 degrees, or greater than 180 degrees.

The heights of the one or more third cavities in the z-direction may be substantially equal to the height of the first cavity in the z-direction. The heights of the third cavities may optionally also be equal to the heights of each of the one or more second cavities in the z-direction. Alternatively, the heights of the third cavities may be equal to the heights of the second cavities in the z-direction, but not to the first cavity. Finally, the heights of the first, second and third cavities in the z-direction may all be different, so that (a) the heights of the second cavities lie between the height of the first cavity and the heights of the third cavities, or (b) the heights of the first cavity lies between the heights of the second cavities and the heights of the third cavities, or so that (c) the heights of the third cavities lie between the height of the first cavity and the heights of the second cavities.

### Manufacturing method

Any quantum processing circuit described in this disclosure may for example be manufactured by:
- Providing a substrate which has a first surface and a second surface and a substrate body between the first surface and the second surface.
- Forming a resonator in the substrate body, wherein the resonator extends from the second surface of the substrate toward the first surface of the substrate.
- Forming circuit elements on the first surface of the substrate.

The circuit elements may include at least one qubit which is formed adjacent to the resonator.

## Claims

1. A quantum processing circuit comprising a substrate, wherein
- the substrate defines an xy-plane and a z-direction which is perpendicular to the xy-plane, and
- the substrate comprises a first surface and a second surface, and
- the substrate comprises a substrate body which extends from the first surface to the second surface, and
- the quantum processing circuit comprises one or more circuit elements on the first surface of the substrate, and
**characterized in that** the quantum processing circuit also comprises a resonator arranged in the substrate body, and the resonator is arranged at a distance, in the z-direction, from the one or more circuit elements on the first surface of the substrate, so that the resonator extends in the z-direction from the second surface of the substrate into the substrate body and toward the one or more circuit elements.

2. A quantum processing circuit according to claim 1, wherein the substrate body comprises a first cavity, and the first cavity is delimited in the xy-plane at least by a first central wall, and the first cavity extends in the z-direction from the second surface of the substrate into the substrate body and toward the one or more circuit elements on the first surface of the substrate, and the resonator comprises a central conductor formed by a first layer of conductive material on the first central wall of the first cavity.

3. A quantum processing circuit according to claim 2, wherein a second central wall surrounds the first central wall in the xy-plane and the resonator also comprises a peripheral conductor formed by a second layer of conductive material on the second central wall of the first cavity.

4. A quantum processing circuit according to claim 2, wherein
- the substrate body comprises two or more second cavities which extend in the z-direction from the bottom surface of the substrate into the substrate body and toward the one or more circuit elements on the first surface of the substrate, and each of the two or more second cavities is delimited in the xy-plane at least by a first peripheral wall, and
- wherein the two or more second cavities are located around the first cavity in the xy-plane, and
- the resonator also comprises a peripheral conductor in each second cavity, and said peripheral conductor is formed by a second layer of conductive material on the first peripheral wall of said second cavity.

5. A quantum processing circuit according to claim 4, wherein the height of the first cavity in the z-direction is substantially equal to the height of each of the two or more second cavities in the z-direction.

6. A quantum processing circuit according to claim 2, wherein
- the substrate body comprises a second cavity which extends in the z-direction from the bottom surface of the substrate into the substrate body and toward the one or more circuit elements on the first surface of the substrate, and
- the second cavity is delimited at least by a first peripheral wall, and
- the second cavity surrounds the first cavity in the xy-plane, and
- the resonator comprises a peripheral conductor in the second cavity, and the peripheral conductor is formed by a second layer of conductive material on the first peripheral wall of the second cavity.

7. A quantum processing circuit according to claim 6, wherein the height of the first cavity in the z-direction is substantially equal to the heights of each of the one or more second cavities in the z-direction.

8. A quantum processing circuit according to any of claims 4-7, wherein
- the substrate body comprises two or more third cavities which extend in the z-direction from the bottom surface of the substrate into the substrate body and toward the one or more circuit elements on the first surface of the substrate,
- and the one or more third cavities are located between the first cavity and the one or more second cavities in the xy-plane, and
- the one or more third cavities are filled with a material which has higher electric permittivity than the substrate body.

9. A quantum processing circuit according to claim 8, wherein the heights of the one or more third cavities in the z-direction is substantially equal to the height of the first cavity in the z-direction.

10. A quantum processing circuit according to any preceding claim, wherein the first cavity is delimited in the xy-plane by the first central wall and a second central wall, so that the first cavity extends from the first central wall to the second central wall.

11. A quantum processing circuit according to any preceding claim, wherein the first central wall is circular in the xy-plane.

12. A quantum processing circuit according to any preceding claim, wherein the resonator also comprises a material with high electric permittivity which fills the first cavity.

13. A quantum processing circuit according to any preceding claim, wherein the first layer of conductive material is a superconducting material.

14. A quantum computing system comprising a quantum processing circuit according to any of claims 1-13.

15. A quantum computing arrangement comprising a quantum processing circuit according to any of claims 1-13.
